# FASCICULE DE BREVET EUROPEEN

(11) **EP 2 697 689 B1**
(45) Date de publication et mention de la délivrance du brevet: **22.07.2015**
(21) Numéro de dépôt: 12713162.1
(22) Date de dépôt: 12.04.2012
(51) Int. Cl.: G03F 7/20, G03F 9/00, H01L 21/768

(54) **PROCÉDÉ DE LITHOGRAPHIE**
LITHOGRAFISCHES VERFAHREN
LITHOGRAPHY PROCESS

(30) Priorité: 12.04.2011 FR 1153176
(43) Date de publication de la demande: 19.02.2014
(73) Titulaire: Commissariat à l'Énergie Atomique et aux Énergies Alternatives, 75015 Paris (FR)
(72) Inventeur: PAULIAC, Sébastien, F-38000 Grenoble (FR)
(74) Mandataire: Hautier, Nicolas
(86) Numéro de dépôt international: PCT/EP2012/056619
(87) Numéro de publication internationale: WO 2012/140106

(56) Documents cités:
- US-A1- 2007 275 311
- US-A1- 2007 275 556
- US-A1- 2011 003 256
- SCHEER H-C ET AL: "Aspects of hybrid pattern definition while combining thermal nanoimprint with optical lithography", JOURNAL OF VACUUM SCIENCE AND TECHNOLOGY: PART B, AVS / AIP, MELVILLE, NEW YORK, NY, US, vol. 28, no. 6, 19 octobre 2010 (2010-10-19), pages C6M1-C6M6, XP012144384, ISSN: 1071-1023, DOI: 10.1116/1.3498750
- M. WISSEN, N. BOGDANSKI, S. MOELLENBECK, H.-C. SCHEER: "Strategies for hybrid techniques of UV lithography and thermal nanoimprint", SPIE, PO BOX 10 BELLINGHAM WA 98227-0010 USA, vol. 6792, 17 avril 2008 (2008-04-17), XP040430606,
- PFEIFFER K ET AL: "Multistep profiles by mix and match of nanoimprint and UV lithography", MICROELECTRONIC ENGINEERING, ELSEVIER PUBLISHERS BV., AMSTERDAM, NL, vol. 57-58, 1 septembre 2001 (2001-09-01), pages 381-387, XP004302289, ISSN: 0167-9317
- JIAN (JIM) WANG: "TUTORIAL: Status of nanoimprint lithography and device applications", SPIE PROC., vol. 6013, no. 6013, 24 octobre 2005 (2005-10-24), pages 601302-1-601302-15, XP040212253, DOI: 10.1117/12.630002

## Description

### DOMAINE TECHNIQUE DE L'INVENTION

La présente invention concerne la lithographie des circuits intégrés en général et décrit plus particulièrement un procédé de lithographie faisant intervenir plusieurs lithographies.

L'invention a pour application particulièrement avantageuse un procédé de lithographie permettant de graver des motifs sur différentes épaisseurs.

### ÉTAT DE LA TECHNIQUE

Avec l'intégration toujours plus grande des circuits produits par l'industrie de la microélectronique, la lithographie, technique essentielle utilisée à tous les stades de production de ces dispositifs, doit faire face à de nombreux défis pour pouvoir soutenir cette évolution.

En particulier, alors que la lithographie a été pendant des dizaines d'années une technique qui s'intéressait essentiellement à la production de motifs toujours plus petits et toujours plus précis, cependant dans un seul plan, on lui demande maintenant, qu'au cours d'une seule étape de fabrication, la gravure du ou des matériaux sous-jacents puisse aussi se faire sur au moins deux épaisseurs différentes.

Un exemple représentatif de cette évolution est la technique permettant la réalisation, au cours d'une même phase de fabrication, d'une ligne horizontale de câblage participant à l'interconnexion des dispositifs d'une couche supérieure d'un circuit intégré et, simultanément, des interconnexions verticales, c'est-à-dire les vias, pour connecter la couche supérieure à une couche inférieure déjà réalisée. Au moins cinq couches de câblage sont en effet le plus souvent nécessaires pour pouvoir interconnecter tous les composants d'un circuit intégré et il est important de réduire autant que se peut le nombre des étapes de fabrication. Connue sous le vocable anglais de « dual damascene » ou « damascene », c'est-à-dire respectivement « double damasquinage » ou « damasquinage » en référence au procédé médiéval d'incrustation de métaux, cette technique suppose que les emplacements des lignes d'interconnexions et des vias soient préalablement formés dans une couche d'oxyde déposée sur la couche d'interconnexion précédente. Des tranchées destinées à former les lignes d'interconnexion y sont gravées qui préservent une couche d'oxyde sous jacente servant d'isolant électrique. Les emplacements des vias sont réalisés, à l'intérieur des tranchées, sous forme de trous verticaux dans l'oxyde jusqu'à atteindre la couche inférieure à interconnecter. Il faut donc pouvoir réaliser deux épaisseurs de gravure différentes, une pour les tranchées et celle correspondant aux trous verticaux des vias. L'avantage de cette technique est que les trous verticaux et les tranchées d'interconnexion sont ensuite remplis, au cours d'une même opération de dépôt, par un métal sur toute la surface d'un substrat formé typiquement par une tranche de silicium. Les interconnexions sont effectivement formées après qu'un polissage mécano chimique de la tranche enlève le métal en excès et laisse seulement celui incrusté dans les tranchées et dans les trous verticaux destinés à former les vias.

De nombreuses mises en oeuvre du double damasquinage ont été proposées qui ont cependant en commun la difficulté de devoir positionner précisément les deux niveaux de gravure de l'oxyde l'un par rapport l'autre c'est-à-dire les trous verticaux destinés à former les vias par rapport aux tranchées destinés à former les lignes d'interconnexion. Il est donc délicat de maîtriser la définition des motifs finaux obtenus. Cet inconvénient lié à la définition des motifs finaux est d'autant plus problématique que les motifs finaux présentent de très petites dimensions.

La présente invention a pour objectif de limiter au moins cet inconvénient. Plus particulièrement, elle a pour objectif d'améliorer la définition des motifs nécessitant plusieurs étapes de lithographie SCHEER H-C ET AL ("Aspects of hybrid pattern définition while combining thermal nanoimprint with optical lithography", JOURNAL OF VACUUM SCIENCE AND TECHNOLOGY: PART B, AVS / AIP, MELVILLE, NEW YORK, NY, US, vol. 28, no. 6, 19 octobre 2010 (2010-10-19), pages C6M1-C6M6) divulguent un exemple de procédé lithographique comprenant une étape de nano-impression suivie d'une étape de lithographie ultérieure.

### RÉSUMÉ DE L'INVENTION

La présente invention a pour objet un procédé de lithographie selon la revendication 1 comprenant:
une étape de préparation au cours de laquelle on dispose une couche de résine sur un substrat, une étape de lithographie préalable exécutée pour définir au moins un motif préalable dans la couche de résine et dans lequel l'étape de lithographie préalable comprend une étape de nano-impression au cours de laquelle un moule comportant des reliefs pénètre dans la couche de résine pour générer le au moins un motif préalable, chaque motif préalable définissant un creux dans la couche de résine et pour définir au moins une marque de positionnement formant un relief en creux dans la couche de résine. En outre, la procédé comprend au moins une étape de lithographie ultérieure appliquée à la couche de résine et comprenant les étapes suivantes :
   - une étape préalable de positionnement consistant à positionner des moyens de lithographie en fonction de la au moins une marque de positionnement,
   - au moins une étape de formation de motifs additionnels en creux dans la couche de résine utilisant les moyens de lithographie positionnés en fonction de la au moins une marque de positionnement, l'étape de formation des motifs additionnels comprenant une exposition d'une partie au moins de l'au moins un motif préalable.

Si l'exposition de la résine provoque la disparition de la résine exposée, le motif préalable est formé par une zone emboutie et le motif additionnel est alors également effectué en creux sur la zone emboutie. On peut ainsi par exemple obtenir un motif formé par des creux qui présentent au moins deux profondeurs différentes ou deux hauteurs différentes à l'intérieur de la couche résine, soit au moins deux marches d'escalier. En effet, le motif préalable définit une première profondeur et le motif additionnel, superposé au motif préalable, définit une deuxième profondeur. La profondeur se détermine par rapport à la surface libre de la couche de résine, c'est-à-dire par rapport à la face de la couche de résine par laquelle pénètre le moule lors de la nano-impression. La hauteur se détermine par rapport à la face de la couche de résine qui est au contact du substrat sur laquelle elle repose.

Si l'exposition de la résine provoque la disparition de la résine en dehors de la zone exposée (résine photosensible négative insolée), le motif final peut alors par exemple former une saillie présentant une première hauteur correspondant sensiblement à l'épaisseur de résine avant la lithographie ultérieure et une deuxième hauteur, moindre et correspondant à une zone emboutie lors de la nano-impression.

La ou les marques de positionnement en relief permettent donc de positionner des étapes successives de lithographie les unes par rapport aux autres et de manière très précise. Les motifs obtenus au cours de l'étape de lithographie préalable sont donc bien positionnés par rapport aux motifs obtenus au cours des étapes de lithographie ultérieure. Les motifs finaux, formés dans deux niveaux de profondeur, présentent donc une bonne définition tout en étant possiblement de taille faible, typiquement inférieure au micromètre.

En outre, les marques sont réalisées dans la résine. L'invention ne nécessite donc pas de créer les marques de positionnement dans le substrat et préalablement à la définition des motifs. Elle permet alors d'éviter des étapes de gravure et d'élimination de résine, habituellement désignée par le vocable anglais stripping, qui sont habituellement nécessaires à la création de marques dans le substrat mais qui dégradent ce dernier. En particulier, il s'est avéré que les solutions ou techniques de gravure et d'élimination de résine peuvent dégrader les couches inférieures du substrat. La mise en oeuvre d'étapes de gravure peut donc être préjudiciable particulièrement lorsque le substrat comporte sous la résine des couches de circuit intégré déjà réalisées.

L'invention a donc également pour avantage de préserver l'intégrité du substrat et des éventuelles couches qu'il comporte.

En outre, l'invention permet de former les marques de positionnement au cours d'une étape de formation de motifs. Elle tend donc à réduire le nombre total d'étapes et donc les coûts.

De manière facultative, le procédé selon l'invention peut présenter au moins l'une quelconque des étapes et caractéristiques optionnelles suivantes :
Au moins l'un parmi les motifs additionnels est superposé à l'au moins un motif préalable de sorte à former au moins un motif en trois dimensions dans la couche de résine.

De manière alternative, à la formation de motifs en trois dimensions, les motifs additionnels ne sont donc pas superposés à l'au moins un motif préalable. On obtient ainsi des motifs en deux dimensions dont les positionnements relatifs sont améliorés.

L'étape de positionnement comprend la détection des marques de positionnement par diffraction de lumière.

Avantageusement, au moins un motif additionnel est superposé à au moins un motif préalable.

L'étape de formation des motifs additionnels est effectuée de sorte à former au moins un motif final en creux présentant au moins deux niveaux de profondeur dans la couche de résine. Alternativement, l'étape de formation des motifs additionnels est effectuée de sorte à former au moins un motif final en saillie présentant au moins deux niveaux de hauteur.

Le procédé comprend, suite à l'au moins une étape de lithographie ultérieure, une étape de transfert consistant à transférer le au moins un motif préalable et les motifs additionnels depuis la couche de résine dans le substrat.

Selon une première variante, les marques de positionnement sont conservées à l'issue de l'au moins une étape de lithographie ultérieure. Les marques de positionnement peuvent ainsi être réutilisées par d'autres étapes de lithographie ultérieures, limitant de ce fait le nombre d'étapes nécessaires et simplifiant le procédé de fabrication global. Eventuellement, les marques de positionnement sont par la suite transférées depuis la couche de résine dans le substrat pour être réutilisées par d'autres lithographies de sorte à avoir un bon positionnement relatif de l'ensemble des motifs obtenus par lithographie. En outre le nombre d'étapes nécessaires à l'obtention du produit final sera réduit.

Selon une deuxième variante, les marques de positionnement sont supprimées au cours de l'au moins une étape de lithographie ultérieure. Typiquement, afin de faire disparaître ces marques de positionnement, il suffira de les insoler si la résine est une résine photosensible positive. Si la résine est une résine photosensible négative, il suffira de ne pas insoler ces marques.

Selon une dernière variante, ces marques peuvent être finalement modifiées, après avoir servi à l'alignement, pour former un motif utile qui sera transféré dans le substrat. Avantageusement, dans ces deux dernières variantes on ne perd pas de place au niveau du substrat avec les marques d'alignement. Cette place peut être utilisée pour réaliser des zones fonctionnelles.

L'étape de transfert comprend une étape de gravure de la couche de résine et du substrat. La gravure a avantageusement une sélectivité sensiblement identique pour la résine et pour le substrat. Mais il est possible également d'admettre une certaine sélectivité, on peut s'en servir notamment pour influer sur la forme du motif transféré, en privilégiant une gravure par rapport à l'autre pour obtenir des aspect ratio différents. De manière particulièrement avantageuse, l'étape de gravure comprend une attaque plasma. Ce type de gravure est essentiellement anisotrope c'est-à-dire que la gravure a lieu essentiellement dans une direction perpendiculaire au plan du substrat. Les parois des motifs seront relativement bien préservées, conservant de ce fait les faibles dimensions des motifs. Ce type de gravure permet donc d'améliorer le contrôle de la précision obtenue.

Avantageusement, au moins l'un parmi les motifs additionnels est superposé à l'au moins un motif préalable de sorte à former au moins un motif en trois dimensions et l'étape de transfert est exécutée de sorte à transférer le au moins un motif en trois dimensions depuis la couche de résine dans le substrat pour former dans le substrat au moins un motif final en trois dimensions dans la couche de résine.

Avantageusement, le procédé comprend également une étape d'apport d'un matériau électriquement conducteur dans le au moins un motif final en trois dimensions.

Préalablement à l'étape de préparation, on réalise au moins une couche d'un circuit intégré dans le substrat. En outre, l'étape de transfert et l'étape d'apport sont exécutées de sorte que le matériau électriquement conducteur forme une ligne d'interconnexion ainsi qu'une interconnexion verticale reliant ladite ligne à la au moins une couche du circuit intégré.

La ligne est formée par une tranchée qui s'étend dans un plan sensiblement parallèle à la surface du substrat. L'interconnexion verticale, ou via, est formée par un trou vertical recevant un matériau électriquement conducteur et s'étendant sensiblement perpendiculairement à la surface du substrat et depuis la tranchée. Il s'étend jusqu'à une couche sous jacente du substrat formant ou destinée à former une couche du circuit intégré. L'invention permet ainsi de réaliser des interconnexions de manière particulièrement précise puisque les marques de positionnement permettent de positionner très précisément les trous verticaux par rapport aux tranchées destinées à former les lignes. En outre, l'obtention de ces interconnexions est effectuée sans dégrader les couches sous jacentes du substrat.

Avantageusement, le matériau électriquement conducteur est en cuivre. L'invention s'avère particulièrement avantageuse puisque ce matériau présente comme inconvénient de ne pas être déposable par les techniques habituelles telles de sérigraphie mais qui présente comme avantage de mieux conduire l'électricité que les matériaux usuellement employés avec ces technique habituelles. Le cuivre grâce à ces propriétés de conduction permet ainsi de limiter la puissance nécessaire au fonctionnement du circuit. Il permet également de réduire la largeur des lignes et interconnexions conduisant ainsi à une réduction de la taille des circuits intégrés.

L'étape de lithographie préalable est distincte de l'étape de lithographie ultérieure.

L'étape de lithographie préalable comprend une étape de nano-impression au cours de laquelle un moule comportant des reliefs pénètre dans la couche de résine pour générer la au moins une marque de positionnement et le au moins un motif préalable.

Ce mode de réalisation est particulièrement avantageux puisqu'il permet notamment de générer des marques de positionnement en relief sans nécessiter d'étape de gravure et d'élimination de résine supplémentaire qui pourraient par ailleurs dégrader le substrat. En outre, il ne nécessite pas d'étape de développement de la résine pour obtenir les marques de positionnement en relief, évitant de ce fait toute contamination de la résine par les solutions de développement. La qualité des motifs obtenus par les étapes ultérieures sera donc améliorée.

En outre, ce mode de réalisation permet de définir des motifs de très petite taille.

L'étape de formation de motifs additionnels dans la couche de résine comprend une étape de photolithographie ou une étape de lithographie par faisceau d'électrons ou une étape de lithographie par faisceau d'ions.

La succession d'une étape de lithographie par nano-impression suivie d'une étape de lithographie optique, électronique ou ionique positionnée par rapport à l'étape de lithographie par nano-impression permet de définir des motifs d'une très grande précision et dont la position relative est parfaitement maîtrisée.

L'étape de nano-impression est effectuée de manière à ce que le au moins un motif préalable définisse un creux dans la résine et à ce que l'étape de formation de motifs additionnels est effectuée de sorte à ce que au moins l'un des motifs additionnels soit au moins partiellement superposé audit motif préalable définissant un creux. Ce procédé permet donc de générer dans la résine des motifs en trois dimensions dont la précision de la forme est améliorée. En particulier ce mode de réalisation s'avère très avantageux pour obtenir des motifs en trois dimensions dont les dimensions sont réduites, typiquement inférieures à 100 voire 50 nanomètres et dont la maîtrise de la forme est améliorée.

En outre ce mode de réalisation permet d'obtenir des motifs en trois dimensions isolés les uns des autres. Les techniques connues de formation de motifs en trois dimensions se basent sur une continuité de certains motifs afin de limiter les conséquences, sur la forme des motifs finaux, des imprécisions de positionnement relatif entre les étapes successives de lithographie.

Le procédé selon l'invention permet ainsi d'obtenir des motifs en trois dimensions, de petite taille et isolés les uns des autres.

Selon un mode de réalisation, l'étape de formation de motifs additionnels est effectuée de sorte à ce que au moins l'un des motifs additionnels est au moins partiellement superposé audit motif préalable définissant un creux et de sorte à faire disparaître les résidus de résine dans le fond du creux ou de sorte à créer des trous s'étendant depuis le creux jusqu'au substrat.

Ce procédé selon l'invention permet ainsi de faire disparaître la résine dans le fond des motifs si toute la largeur du motif préalable, soit toute la zone emboutie lors de la lithographie préalable, est recouverte par le motif additionnel. On résout ainsi un inconvénient important de la lithographie par nano-impression.

Alternativement, en ne faisant disparaître la résine que sur une partie du motif préalable, c'est-à-dire que sur une partie de la zone emboutie lors de la lithographie préalable, on peut alors réaliser des ouvertures permettant une communication entre le motif préalable et le substrat. Les motifs finaux ainsi obtenus permettent typiquement de réaliser des interconnexions verticales entre plusieurs niveaux d'un circuit intégré.

Selon un mode de réalisation avantageux, la résine est une résine photosensible, l'étape de formation de motifs additionnels dans la couche de résine comprend une étape de photolithographie et ladite exposition comprend une insolation d'une partie au moins de l'au moins un motif préalable.

Selon un mode de réalisation avantageux, l'étape de formation de motifs additionnels dans la couche de résine comprend une étape de lithographie par faisceau d'électrons ou une étape de lithographie par faisceau d'ions et l'exposition comprend une écriture d'une partie au moins de l'au moins un motif préalable.

Selon un mode de réalisation avantageux, la résine est une résine photosensible positive, l'étape de lithographie ultérieure comprend une étape de photolithographie comprenant une étape d'insolation effectuée de sorte à faire disparaître les résidus de résine dans le fond du creux ou de sorte à créer des trous s'étendant depuis le creux jusqu'au substrat.

L'étape de lithographie préalable définie des premières zones présentant une première épaisseur et des deuxièmes zones présentant chacune une épaisseur inférieure à la première épaisseur, et dans lequel la au moins une étape de lithographie ultérieure est effectuée de sorte à faire disparaître la résine au moins en partie dans au moins certaines des deuxièmes zones. Le procédé permet ainsi de faire disparaître des résidus de résine dans le fond des deuxièmes zones ou de créer des trous s'étendant depuis ces deuxièmes zones jusqu'au substrat.

Selon un mode de réalisation l'étape de formation de motifs additionnels dans la couche de résine comprend une étape de photolithographie ou une étape de lithographie par faisceau d'électrons ou une étape de lithographie par faisceau d'ions.

Selon un autre mode de réalisation l'étape de formation de motifs additionnels comprend une étape de nano-impression au cours de laquelle un moule comportant des reliefs pénètre dans la couche de résine pour générer les motifs additionnels.

Le procédé peut également comprendre plusieurs étapes de lithographie ultérieures comprenant chacune une étape de formation de motifs additionnels prise parmi : une étape de nano-impression, une étape de photolithographie, une étape de lithographie par faisceau d'électrons, une étape de lithographie par faisceau d'ions.

En particulier, on prévoit qu'une première étape de lithographie ultérieure comprend une étape de photolithographie et qu'une deuxième étape de lithographie ultérieure comprend l'une parmi les étapes suivantes : une étape de photolithographie, une étape de lithographie par faisceau d'électrons, une étape de lithographie par faisceau d'ions.

L'invention permet ainsi de réaliser plusieurs lithographies sans effectuer d'étapes préliminaires de génération de marques d'alignement dans le substrat. Ainsi on réduit le nombre d'étapes (et donc le coût) pour réaliser une combinaison de lithographies avec alignement.

De préférence, la marque de positionnement forme un relief en creux dans la couche de résine. Alternativement, la marque de positionnement forme un relief en saillie dans la couche de résine.

Selon une possibilité la marque de positionnement forme un motif préalable. La marque de positionnement servant au positionnement des étapes de lithographie ultérieures est donc également transférée dans le substrat.

Selon une possibilité les motifs préalables présentent une profondeur inférieure à la profondeur des marques d'alignement.

Selon un autre aspect, l'invention a pour objet un ensemble multicouches obtenu selon l'un quelconque des modes de réalisation de la méthode exposée ci-dessus.

L'invention a encore pour objet un ensemble multicouches selon la revendication 18 comprenant un substrat surmonté d'une couche de résine caractérisé en ce que la couche de résine comprend au moins une marque de positionnement formée en relief dans la couche de résine et configurée pour permettre le positionnement d'un appareil de lithographie relativement à cette au moins une marque de positionnement.

De manière optionnelle mais particulièrement avantageuse, la au moins une marque de positionnement est obtenue par nano-impression.

Avantageusement, la au moins une marque de positionnement présente une profondeur supérieure à la profondeur des motifs préalables.

Selon un mode de réalisation particulier, le motif final présente plus de deux niveaux de profondeur ou plus de deux hauteurs. Avantageusement, le moule présente des reliefs présentant plusieurs hauteurs pour définir des motifs préalables de profondeur différentes.

Un autre objet de la présente invention concerne un procédé de fabrication d'un dispositif microélectronique selon la revendication 19 à partir d'un ensemble multicouches selon l'invention, comprenant au moins une étape de lithographie pour générer des motifs dans la couche de résine de l'ensemble multicouches et faisant intervenir un appareil de lithographie. L'étape de lithographie comprend une étape de positionnement de l'appareil de lithographie. L'étape de positionnement comprend une étape de détection de l'au moins une marque de positionnement formée en relief dans la couche de résine et une étape de positionnement de l'appareil de lithographie par rapport à l'au moins une marque de positionnement.

Avantageusement, l'étape de lithographie comprend en outre une étape de formation de motifs additionnels dans la couche de résine utilisant l'appareil de lithographie positionné en fonction de la au moins une marque de positionnement, l'étape de formation des motifs additionnels comprenant l'exposition d'une partie au moins de l'au moins un motif préalable de sorte à former au moins un motif final en creux présentant au moins deux niveaux de profondeur dans la couche de résine ou un motif final en saillie présentant au moins deux niveaux de hauteur.

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1, comprenant les figures 1 a à 1 g, illustre un exemple de mode de réalisation du procédé selon l'invention, cet exemple de procédé permettant de réaliser une lithographie tridimensionnelle avec une excellente définition.
La FIGURE 2 illustre le positionnement optimum des dispositifs sur une tranche en cours de fabrication.

Les dessins joints sont donnés à titre d'exemples et ne sont pas limitatifs de l'invention.

### DESCRIPTION DÉTAILLÉE DE L'INVENTION

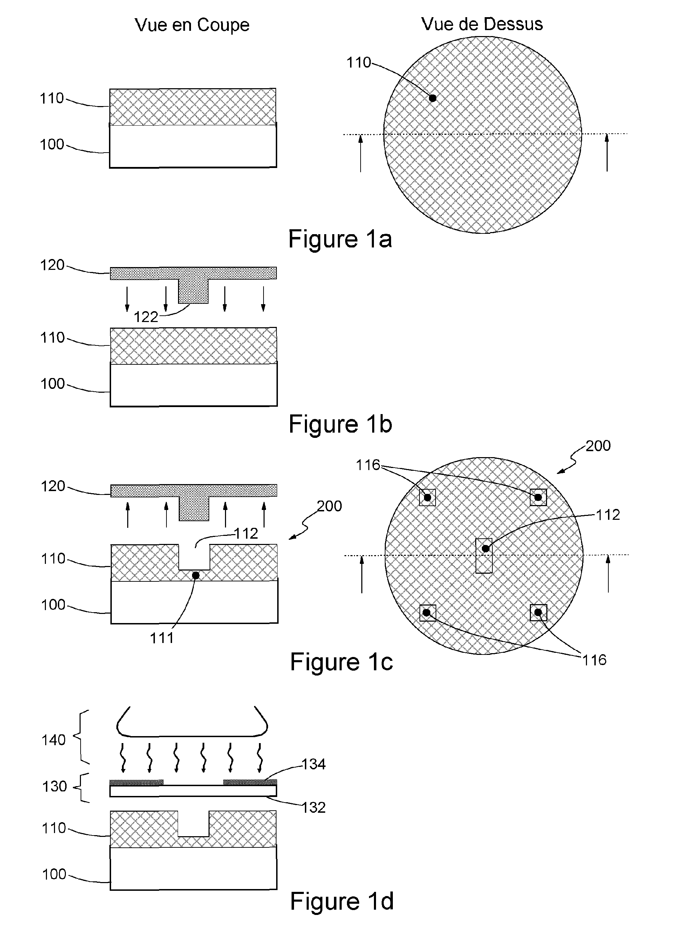

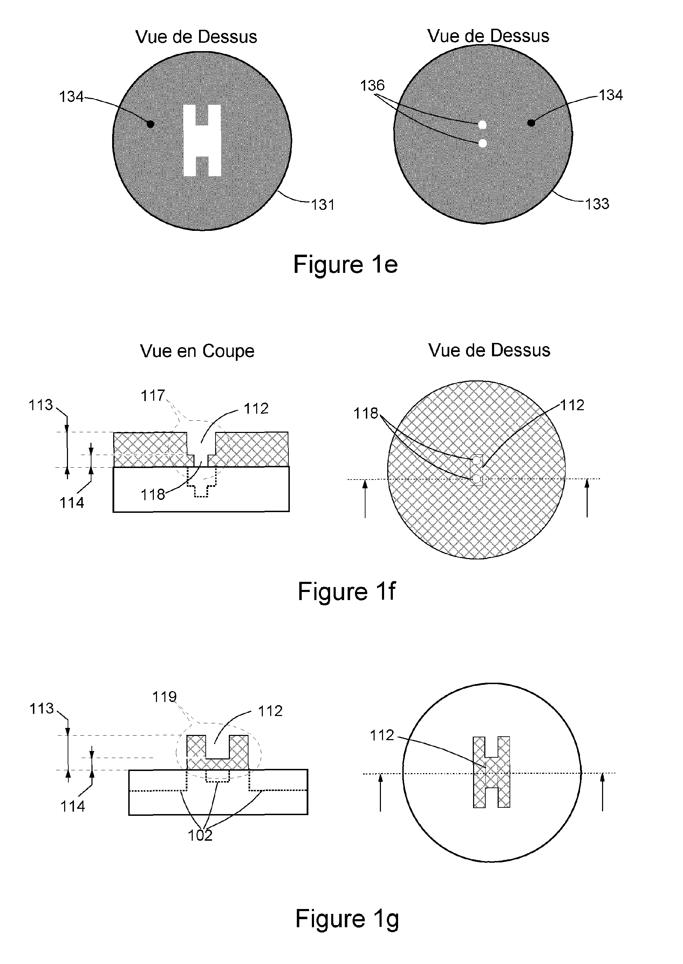

La figure 1, qui comprend les figures 1 a à 1 g, illustre les étapes principales de mise en oeuvre du procédé selon l'invention qui permet de réaliser une lithographie tridimensionnelle avec une excellente définition. Comme cela sera rappelé par la suite, la présente invention n'est pas limitée à la réalisation de motifs en trois dimensions. Cependant la réalisation de motif en trois dimensions fait ressortir de manière particulièrement explicite les avantages de l'invention. Dans le cadre de la présente invention, on désigne par motif en trois dimensions un motif présentant dans une couche donnée, par exemple une résine ou un substrat, au moins deux niveaux de profondeur au dessous de la face supérieure de la couche lorsque le motif est en creux ou au moins deux niveaux de hauteur au dessus d'une face supérieure de la couche lorsque le motif est en saillie. Cela apparaît clairement sur les figures 1f et 1g par exemple qui seront décrites en détail par la suite.

L'invention combine plusieurs types de lithographie qui ont été développés au fil des ans. La lithographie par impression nanométrique, de l'anglais « nanoimprint lithography » ou NIL, consiste à définir des motifs de taille nanométrique à partir d'un moule que l'on imprime. Cette technique connue depuis le milieu des années 90 fait désormais partie de la feuille de route internationale des technologies pour les semiconducteurs ou ITRS « international technology roadmap for semiconductors ».

Comme illustré en **figure 1a** l'invention met en oeuvre cette technique en partant d'une couche sensiblement uniforme de résine 110. Cette couche de résine 110 est déposée d'une façon traditionnelle sur les dispositifs en cours de fabrication. Typiquement elle est déposée par centrifugation usuellement désignée « spin coating ». L'invention ne fait pas d'hypothèse sur la nature du dispositif en cours de fabrication. Il s'agira typiquement d'un circuit intégré, ou de n'importe quel type de dispositif, optoélectronique ou électromécanique, développé et produit par l'industrie de la microélectronique et qui requiert l'emploi de la lithographie pour définir des motifs géométriques à chaque étape de fabrication. Le substrat 100 ou support sur lequel est déposé la couche de résine 110 est donc par exemple une tranche d'un semi conducteur sur lequel sont élaborés des dispositifs. La tranche est par exemple constituée d'un semi conducteur cristallin, typiquement de silicium. La couche de résine 110 couvre le substrat 100 ou tranche sur toute sa surface. Le substrat 100 peut être à un stade avancé de sa fabrication. Notamment, chaque substrat peut déjà comporter un grand nombre de couches diverses, non représentées, portant un très grand nombre de motifs.

L'étape suivante, schématisée sur la **figure 1b**, est une étape de lithographie préalable. Elle consiste notamment à imprimer dans la couche de résine 110 les motifs en relief 122 d'un moule 120 servant à définir une partie des motifs d'épaisseurs différentes à réaliser dans la couche à graver. Typiquement, dans le cas d'une mise en oeuvre de l'invention pour le double damasquinage discuté dans le chapitre sur l'état de la technique, il s'agit là de former dans la résine 110, à l'aide du moule, les tranchées qui, après transfert dans une couche d'oxyde sous jacente, seront remplies du métal utilisé pour former les lignes interconnexions.

Le retrait du moule qui est schématisé sur la **figure 1c** peut s'effectuer après solidification de la résine 110. Le moule étant en place, la mise en forme est obtenue en chauffant l'ensemble (moule, résine 110 et substrat 100), à une température qui ne doit pas excéder la température de réticulation dans le cas d'une résine photosensible négative ou la température de déprotection thermique dans le cas d'une résine photosensible positive afin de préserver toutes leurs propriétés photosensibles. La solidification s'opère après l'étape de chauffage. Cette technique est plus connue sous l'acronyme TNIL pour thermal nanoimprint lithography, soit lithographie combinée à une nano impression thermique.

Le moule laisse dans la résine 110 autant d'empreintes 112 qu'il y a de reliefs 122 dans celui-ci. Par souci de clarté, sans que cela ne gêne en rien la description de l'invention ni n'en limite sa portée, une seule empreinte 112 est ici représentée. En pratique, par exemple pour réaliser un circuit intégré dont les plus denses peuvent maintenant comprendre des centaines de millions de transistors voire dépasse le milliard, un nombre correspondant de motifs pourra devoir être imprimé par le moule au cours d'une seule opération d'impression. On notera également que l'échelle à laquelle l'empreinte 112 unique est représentée est sans commune mesure avec la représentation du substrat 100 et du moule 120. Les substrats ou tranches ont en effet couramment un diamètre jusqu'à plusieurs dizaines de centimètres (10⁻² mètre), typiquement 30 centimètres, alors que les motifs à imprimer se mesurent en dizaines de nanomètres (10⁻⁹ mètre).

L'invention prévoit que des marques de positionnement 116, également désignées marques d'alignement, sont imprimées dans la résine 110 au cours de la même opération d'impression et sont donc présents sur le moule, comme les motifs, sous forme de reliefs. Ces marques de positionnement 116 sont utilisées d'une façon standard par les dispositifs de positionnement des substrats. Elles vont servir à l'opération de lithographie suivante décrite ci-après.

Cette étape a donc permis la définition d'un ensemble multi couches 200 comprenant un substrat 100, une couche de résine 110 dans laquelle au moins une marque de positionnement 116 et de préférence plusieurs marques de positionnement 116 sont formées.

Dans le mode de réalisation illustré, les marques de positionnement 116 sont non fonctionnelles pour les circuits en cours de fabrication. Elles ont pour unique fonction de permettre le positionnement de plusieurs lithographies successives. En effet, ces marques présentent habituellement des formes spécifiques qui facilitent leur détection par les systèmes de détection et de positionnement.

Dans le cadre de la présente invention, les marques présentent des formes standard aptes à être détectées par les systèmes habituels de positionnement. Selon une variante de réalisation, les marques servent également à la définition de motif du circuit à réaliser. Le nombre et la disposition des marques sur le substrat 100 dépendent du type de système de positionnement utilisé. Elles sont par exemple au nombre de quatre et situées, comme représenté, près de la périphérie des substrats là où les défauts de positionnement peuvent se constater avec une plus grande amplitude.

Dans toutes les empreintes 112 laissées par le moule on remarquera qu'il reste une épaisseur 111 contrôlée de résine 110 qui dépend de l'épaisseur initiale de résine 110 déposée par centrifugation et de la hauteur des reliefs 122 du moule 120. Dans la mise en oeuvre standard de la lithographie par impression nanométrique ceci est considéré comme un résidu qu'il est nécessaire d'enlever avant de pouvoir transférer les motifs imprimés dans la couche sous jacente à graver. Comme on va le voir ci-après l'invention tire avantage de cet inconvénient pour obtenir des épaisseurs de résine différentes au cours d'une même opération de lithographie.

L'étape de lithographie préalable consiste donc à former dans la couche de résine des motifs préalables et des marques de positionnement. Dans l'exemple illustré cette étape comprend une impression nanométrique. Néanmoins, les motifs préalables et les marques de positionnement peuvent être formés dans la résine par une lithographie optique ou par faisceau d'ions ou par faisceau d'électrons. Pour cela, on peut prévoir avantageusement de déposer une bicouche de résine photosensible, les deux couches de résine ayant soit des tonalités différentes, soit si elles ont la même tonalité, des sensibilités différentes à l'insolation. On pourra par exemple utiliser un empilement d'une résine négative, par exemple au contact du substrat, et d'une résine positive. On viendra ensuite insoler et développer cette résine positive pour former les motifs souhaités.

Cette étape de lithographie préalable est suivie d'au moins une étape de lithographie ultérieure appliquée à la couche de résine. Pour chaque étape de lithographie ultérieure on effectue un positionnement par rapport aux marques de positionnement, puis une étape de formation de motifs additionnels dans la couche de résine. De manière connue l'étape de positionnement comprend une étape de détection et de localisation des marques de positionnement.

Dans l'exemple illustré sur la **figure 1d** l'étape de formation des motifs additionnels comprend une étape de lithographie optique. Il s'agit d'une opération standard d'insolation 140 de la résine à travers un masque 130 qui aura pu être positionné très précisément grâce aux marques de positionnement 116 imprimées par le moule lors de l'étape de lithographie préalable. Le masque est de façon standard un masque fait d'un matériau transparent 132, du quartz, sur lequel des motifs opaques en chrome 134 ont été formés. Selon la mise en oeuvre particulière de cette opération standard de lithographie optique, le masque, après positionnement, pourra être appliqué soit directement sur la couche de résine 110 (lithographie par contact) soit à proximité pour l'insoler sélectivement à travers les parties transparentes. Le masque peut être aussi un réticule, c'est-à-dire un masque agrandi généralement d'un seul des dispositifs en cours de fabrication. L'image réduite du réticule est alors projetée et répétée avec des moyens optiques et mécaniques appropriés, non représentés, sur toute la surface de résine 110 couvrant le substrat 100 afin d'obtenir une meilleure définition des motifs.

L'étape de formation des motifs additionnels dans la couche de résine de la figure 1d peut être aussi réalisée sans masque en insolant la résine 110 avec un faisceau d'ions ou un faisceau d'électrons guidé pour dessiner chacun des motifs. Cette dernière technique est connue sous les noms de « lithographie par faisceau d'électrons » ou « lithographie électronique » et souvent désignée par l'abréviation « e-beam » de l'anglais « electron beam ». La lithographie électronique est la technique qui permet d'obtenir une résolution très élevée des motifs à graver au prix d'avoir à dessiner séquentiellement chacun des motifs de chacun des dispositifs d'un substrat. Opération qui est très longue et donc coûteuse.

Ainsi, dans le cadre de la présente invention, on désigne par exposition d'une zone de résine aussi bien une insolation de la zone de résine si la lithographie est une photolithographie ou écriture de la zone de résine si la lithographie est une lithographie par faisceau d'ions ou d'électrons.

L'étape de formation des motifs additionnels dans la couche de résine peut également comprendre une nouvelle impression nanométrique.

Quelle que soit la technique de lithographie utilisée à ce stade, le procédé selon l'invention emploie les marques d'alignement 116 discutées précédemment pour se positionner très précisément par rapport à l'opération d'impression nanométrique précédente.

La figure 1e donne des exemples de masques, 131 et 133, à utiliser respectivement avec une résine photosensible négative et avec une résine photosensible positive afin d'obtenir des épaisseurs de résine différentes.

Avec une résine photosensible positive les zones insolées à travers les parties transparentes du masque 133 deviennent solubles et disparaissent lors de l'opération de développement de la résine qui suit l'insolation. L'utilisation d'une résine positive et d'un masque de type 133 se prête donc bien à une utilisation de l'invention pour le double damasquinage discuté dans le chapitre sur l'état de la technique. Dans ce cas, la surface des ouvertures 136 du masque est très faible et correspond dans cet exemple aux trous d'interconnexion 118 qui doivent être formés dans les empreintes 112 laissées par le moule 120 dans la résine. Le masque 133 est donc majoritairement couvert de chrome 134. À nouveau, on notera que par souci de clarté seuls deux trous d'interconnexion, sont représentés sur le masque 133 alors qu'en pratique un très grand nombre devront bien sûr être formés pour assurer les interconnexions verticales entre la couche en cours de réalisation et la couche inférieure déjà réalisée.

Le résultat de la lithographie optique correspondant à l'utilisation d'une résine positive avec le masque de type 133 est montré sur la **figure 1f**, en coupe à travers l'un des motifs additionnels 118 forment des trous d'interconnexion, et en vue de dessus. Les deux trous d'interconnexion de cet exemple sont formés au fond des tranchées 112 correspondant aux zones embouties par le moule 120 après insolation et développement de la résine 100. On obtient bien deux épaisseurs de résine : 113 et 114. Comme indiquées par des flèches sur les figures, ces épaisseurs sont définies depuis la face de la couche de résine 110 qui repose sur le substrat 100. La zone 114 a été emboutie par le moule. L'épaisseur de cette zone a donc diminuée par rapport à l'étape 1a. La zone 113 n'a pas été ou a été faiblement emboutie par le moule. En outre la zone correspondant au motif additionnel 118 définit une autre épaisseur de résine qui est nulle. La structure du motif final 117 avant transfert présente donc deux hauteurs différentes de creux dans la couche de résine, une hauteur de creux nulle correspondant à la zone 108 et une hauteur de creux 114 correspondant au creux laissé par les empreintes 112 du moule 120. Autrement dit, le motif final 117 présente deux profondeurs différentes, une profondeur égale à l'épaisseur de la couche de résine et qui est obtenue à l'issue de la lithographie ultérieure et une profondeur inférieure formée par le creux laissé par les empreintes 112 du moule 120. A l'issue de la lithographie ultérieure, on obtient ainsi bien un motif 117 présentant deux niveaux de profondeur dans la résine. On peut donc mesurer au moins trois épaisseurs de résine différentes et dans un ordre croissant: une première épaisseur 113 là où la couche n'a pas été modifiée ou a été faiblement modifiée, une deuxième épaisseur 114 définie par un creux formé lors de la lithographie préalable et une troisième épaisseur définie par un creux formé lors de la lithographie ultérieure, cette épaisseur étant nulle dans l'exemple illustré en figure 1f. Les motifs ainsi formés sur deux niveaux dans la résine 110 sont transférables dans la couche sous jacente à l'aide d'une gravure sèche anisotrope permettant de transférer des motifs depuis la résine 110 au substrat 100. Cette gravure peut être purement physique : il n'y a pas de réaction chimique avec le substrat 100, la gravure résulte uniquement du bombardement de l'échantillon par des ions (gravure IBE : ion beam etching soit gravure par faisceau d'électrons). Elle peut également être au moins partiellement chimique (PE plasma etching, RIE reactive ion etching). Si le substrat et la résine présentent une sensibilité sensiblement équivalente à la gravure, les motifs seront transférés sans déformation depuis la résine au substrat. Il est possible également d'admettre un certain degré de sélectivité entre la résine et le substrat pour adapter la forme des motifs transférés.

Utilisée pour mettre en oeuvre la technique de double damasquinage la structure multidimensionnelle du motif final 117 obtenue à l'issue de la seconde lithographie optique servira, après transfert dans une couche d'oxyde sous jacente, à former les lignes d'interconnexion de la couche de câblage correspondante ainsi que les vias avec la couche de câblage inférieure. Le procédé de l'invention n'est en rien limité à être utilisé seulement pour le double damasquinage. Il peut avantageusement servir pour d'autres applications en lithographie chaque fois où il faut pouvoir obtenir deux épaisseurs de résine 110 différentes ou qu'il faudra faire intervenir des opérations de lithographie devant être mutuellement positionnées avec précision.

La **figure 1 g** montre le résultat de l'utilisation d'une résine négative et d'un masque de type 131. Dans le cas d'une résine photosensible négative ce sont les zones insolées qui deviennent insolubles et restent donc en place après développement de la résine. On obtient comme précédemment, après la seconde lithographie optique, deux niveaux de résine (113 et 114) avec un motif final 119 cependant différent pour d'autres applications du procédé. Comme indiqué ci-dessus cette structure de résine est transférée dans la couche sous jacente en ayant recours à une gravure anisotrope ici non sélective du type gravure plasma afin d'obtenir deux profondeurs de gravure différentes 102 sans déformation des motifs 119.

A l'issue de la lithographie ultérieure, on obtient ainsi un motif 119 présentant deux niveaux de profondeur dans la résine. On peut donc mesurer au moins trois épaisseurs de résine différentes et dans un ordre croissant: une première épaisseur 113 là où la couche n'a pas été modifiée ou a été faiblement modifiée, une deuxième épaisseur 114 définie par un creux formé lors de la nano-impression et une troisième épaisseur définie par un creux formé lors de la photolithographie ultérieure, cette épaisseur étant nulle dans l'exemple illustré en figure 1g. Ce motif 119 en trois dimensions peut ainsi être transféré dans le substrat 100.

Le procédé décrit ci-dessus permet d'obtenir un excellent alignement entre les deux niveaux de lithographie. C'est-à-dire, entre l'étape de lithographie préalable (impression nanométrique dans le cas illustré) et l'étape de lithographie ultérieure (lithographie optique dans le cas illustré) en utilisant les marques de positionnement 116 imprimées dans la résine 110 lors de l'étape de lithographie préalable. On obtient ainsi des motifs finaux présentant un parfait positionnement des motifs préalables et des motifs additionnels. Lorsque la combinaison de ces motifs définit des motifs en trois dimensions, ces motifs en trois dimensions présentent alors une très bonne définition.

L'invention se révèle particulièrement avantageuse pour réaliser des motifs 3D isolés et de très petites dimensions, c'est-à-dire avec des dimensions typiquement inférieures à 100 nanomètres.

De manière particulièrement avantageuse, les marques de positionnement sont générées et sont détectées dans la couche résine. L'invention ne nécessite pas d'étape de gravure de marques de positionnement pour les transférer dans le substrat. Aucune étape de gravure ou de stripping ne vient donc dégrader les couches sous jacentes du substrat.

Dans l'exemple détaillé précédemment, l'étape de lithographie préalable comprend uniquement une étape de nano-impression. Cela a pour avantage de générer des marques de positionnement par simple emboutissage de la couche de résine. Cette dernière n'a pas besoin d'être développée pour former les reliefs définissant les marques d'alignement. Or, il s'avère que l'utilisation des solutions de développement habituellement utilisées dans les étapes de lithographie optique, électronique ou par faisceau d'ions dégrade la résine. La sensibilité de cette dernière est dégradée ce qui conduit à une diminution de la résolution lors d'étapes ultérieures de lithographie. Le mode de réalisation de l'invention faisant intervenir une nano-impression pour l'étape de lithographie préalable permet donc d'améliorer très significativement la définition des motifs obtenus.

En outre, les développements successifs de la résine ont tendance à « éroder » les motifs déjà formés, conduisant ainsi à une réduction du rapport de forme et à une dégradation de la géométrie des motifs finaux. Cela s'avère d'autant plus manifeste que les motifs présentent un rapport de forme élevé. Ainsi, l'invention, en prévoyant une étape de nano-impression pour la formation des marques de positionnement et des motifs préalables, permet de réduire le nombre d'étapes de développement et d'améliorer la géométrie des motifs par rapport aux solutions reposant sur de la photolithographie par exemple pour former les marques de positionnement. Par conséquent, des marques de positionnement, même de très petites dimensions et par exemple destinées à être détectées par diffraction conserveront une bonne géométrie après une étape de développement lors de la lithographie ultérieure et pourront être réutilisées pour une lithographie additionnelle.

En outre, l'invention permet l'utilisation de résines photosensibles à tonalité positive ou à tonalité négative.

Selon un mode de réalisation, les reliefs du moule destinés à former les marques d'alignement ne présentent pas la même hauteur que les reliefs du moule destinés à former les motifs préalables. Ainsi, les marques d'alignement et les motifs préalables présentent des profondeurs différentes. Typiquement, la profondeur des marques d'alignement est supérieure à celle des motifs préalables. De préférence, la profondeur de toutes les marques d'alignement est identique et la profondeur de tous les motifs préalables est identique. Cette différence de hauteur des reliefs du moule ou de profondeur des marques et des motifs préalables permet d'effectuer pour ces derniers une nano-impression « partielle » de la couche de résine, c'est-à-dire à faible profondeur afin de pouvoir modeler librement les motifs finaux à réaliser. Pour les marques d'alignement, on effectue avantageusement une nano-impression la plus profonde possible pour en améliorer le rapport de forme et la précision ce qui est très important pour permettre une détection précise, par exemple par diffraction et obtenir un positionnement amélioré.

Par ailleurs, la mise en oeuvre d'une nano-impression permet de former des marques de positionnement de très faibles dimensions. Elles peuvent ainsi convenir à des systèmes de détection par diffraction ce qui permet d'améliorer la précision du positionnement de l'étape ultérieure de lithographie. Typiquement, l'invention permet d'obtenir des marques de positionnement d'une dizaine ou de quelques dizaines de nanomètres. La précision de l'alignement est typiquement inférieure à 100 nanomètres alors qu'avec les aligneurs conventionnels, reposant typiquement sur une détection optique, la précision de l'alignement est supérieure au millimètre. La précision d'alignement offerte par l'invention permet d'obtenir des motifs finaux en trois dimensions de taille réduite et de qualité améliorée. En effet, alors que les procédés connus ne permettent que d'obtenir des motifs en trois dimensions largement supérieurs au micromètre, l'invention permet aisément d'obtenir des motifs en trois dimension inférieurs au micromètre.

L'invention peut aussi s'étendre ainsi aux lithographies hybrides ou composites. Pour rappel une lithographie hybride ou composite met en jeu deux types au moins de lithographie, les motifs effectués au cours des différentes étapes d'une lithographie hybride se chevauchant, alors que les motifs effectués au cours des différentes étapes d'une lithographie composite ne se chevauchent pas.

Le nombre d'étapes de lithographie ultérieures utilisant les marques de positionnement n'est pas limité.

Les marques de positionnement imprimées peuvent ne pas être gravées. Contrairement au procédé standard de lithographie où les motifs et donc les marques de positionnement, sont systématiquement gravés, on a ici la possibilité de les garder ou de les supprimer ou de les modifier en fonction de ce que l'on souhaite réaliser dans la suite d'un processus de fabrication utilisant le procédé de l'invention. Si les marques doivent être supprimées il suffit, dans le cas d'une résine négative, de ne pas les insoler. Si la résine est positive, il faudra au contraire les insoler. Le masque où le réticule sera adapté en conséquence.

On remarquera qu'en gravant les marques de positionnement les étapes de lithographie suivantes pourront les réutiliser sans devoir en générer de nouvelles. On supprime ainsi des étapes de lithographie, gravure et enlèvement de la résine d'où une diminution du taux d'occupation des équipements, des consommables utilisés, conduisant à une diminution du coût de réalisation du dispositif.

Les marques de positionnement imprimées dans la résine possèdent une certaine topographie. C'est par ce biais qu'elles peuvent être détectées par les systèmes de positionnement. Par exemple, les systèmes de détections par diffractions de la lumière peuvent les détecter, tout comme des systèmes de reconnaissance optique. Il existe de nombreux systèmes de positionnement développés par les différents équipementiers. Par exemple pour l'équipementier ASML, on peut citer le système TTL acronyme de through the lens c'est-à-dire à travers la lentille ou le système ATH ENA.

A titre d'exemple, pour un stepper ASML 300, deux types de marques peuvent être utilisés : les marques désignées PM (Primary Marks) ou les marques désignées SPM (Scribelane Primary Marks)

Avec le procédé de l'invention il est possible d'utiliser la plupart des types de marques déjà utilisés d'une façon standard en lithographie pour le positionnement des masques. Si besoin, des adaptations de dimensions, notamment d'épaisseur, pourront être réalisées pour faciliter la détection des motifs réalisés dans la résine par rapport à ceux réalisés classiquement dans le substrat. Par exemple, on pourra, pour les marques PM précédemment définies, augmenter la profondeur de ces marques dans la résine à 400nm contre 120nm pour les mêmes marques réalisées dans des substrats de silicium. Ces ajustements sont à la portée de l'homme du métier qui sait déjà apporter des ajustements similaires en fonction du type de substrats dans lequel ces marques sont réalisées dans l'art antérieur. Il convient de remarquer que les motifs correspondants du moule d'impression devront être bien sûr le miroir des marques standard de positionnement. De plus, il est également nécessaire d'inverser leur topographie. Une marque constituée de tranchées devra être constituées de reliefs sur le moule.

La définition des motifs ainsi réalisés, comparée à une technique par une seule étape de nano impression, est meilleure. En effet, grâce à l'étape de formation de motifs additionnels effectuée lors de l'étape de lithographie ultérieure nous avons la possibilité de minimiser tous les problèmes et défauts inhérents au démoulage.

En particulier, comme déjà noté précédemment, dans la mise en oeuvre standard de la lithographie par impression nanométrique, les parties de résine embouties par le moule sont considérées comme des résidus qu'il faut pouvoir enlever. Si les motifs additionnels couvrent l'ensemble du fond des zones embouties, alors les résidus peuvent être aisément et précisent retirés.

Si les motifs additionnels sont plus petits que le fond des zones embouties et sont ponctuels, alors on peut former des trous verticaux particulièrement utiles pour la création des interconnexions. L'invention permet donc de tirer avantage des résidus inévitablement générés par l'impression nanométrique et qui sont habituellement perçus comme un inconvénient majeur de cette technique.

Un autre avantage de la présente invention réside dans le fait qu'elle est plus simple à mettre en oeuvre que les solutions utilisant des couches sacrificielles ou des anti-réflecteurs. Plus précisément, l'invention permet de réduire le nombre d'étapes habituellement nécessaires avec ces solutions connues. L'invention procure donc des avantages significatifs en terme de simplicité, de fiabilité et de coût.

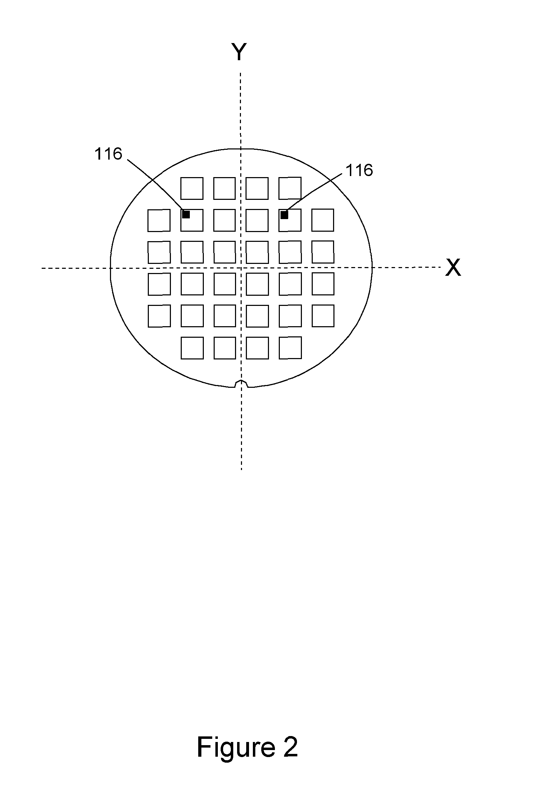

Enfin, pour obtenir une meilleure reprise d'alignement après l'étape d'impression du moule dans la résine 110, il est préférable, comme montré sur la **figure 2**, de créer une nappe symétrique par rapport aux axes X et Y du substrat 100. Ainsi il est plus facile de corriger les erreurs de rotation, translation, expansion et magnification. Naturellement, les marques de positionnement doivent être situées dans des zones de la plaque lisibles par l'équipement de positionnement qui effectuera l'étape de lithographie ultérieure.

L'invention n'est pas limitée aux modes de réalisation précédemment décrits mais s'étend à tout mode de réalisation couvert par les revendications.

## Revendications

1. Procédé de lithographie comprenant: une étape de préparation au cours de laquelle on dispose une couche de résine (110) sur un substrat (100), une étape de lithographie préalable exécutée pour définir au moins un motif préalable (112) dans la couche de résine (110), **caractérisé en ce que**:
• l'étape de lithographie préalable comprend une étape de nano-impression au cours de laquelle un moule (120) comportant des reliefs (122) pénètre dans la couche de résine (110) pour générer le au moins un motif préalable (112) et au moins une marque de positionnement (116) formant un motif dans la couche de résine (110), au moins certains des motifs générés par le moule (120) présentant des profondeurs différentes;
• et **en ce qu'**il comprend au moins une étape de lithographie ultérieure appliquée à la couche de résine (110) et comprenant les étapes suivantes :
- une étape préalable de positionnement consistant à positionner des moyens de lithographie en fonction de la au moins une marque de positionnement (116),
- au moins une étape de formation de motifs additionnels (118) dans la couche de résine (110) utilisant les moyens de lithographie positionnés en fonction de la au moins une marque de positionnement (116), l'étape de formation des motifs additionnels (118) comprenant une étape d'exposition d'une partie au moins d'un motif préalable (112).

2. Procédé selon la revendication 1, dans lequel l'étape de formation des motifs additionnels (118) est effectuée de sorte à former dans la résine (110) au moins un motif final (119) en saillie présentant au moins deux niveaux de hauteur (113, 114) ou est effectuée de sorte à superposer au moins un motif préalable (112) avec un motif additionnel (118) pour former dans la résine (110) au moins un motif final (117) en creux présentant au moins deux niveaux de profondeur dans la couche de résine (110).

3. Procédé selon la revendication 1, dans lequel l'étape de positionnement comprend la détection des marques de positionnement (116) par diffraction de lumière.

4. Procédé selon la revendication 1, dans lequel au moins l'un parmi les motifs additionnels est séparé de l'au moins un motif préalable.

5. Procédé selon la revendication 1, comprenant, suite à l'au moins une étape de lithographie ultérieure, une étape de transfert consistant à transférer le au moins un motif préalable (112) et les motifs additionnels (118) depuis la couche de résine (110) dans le substrat (100).

6. Procédé selon la revendication précédente, dans lequel l'au moins une marque de positionnement (116) est conservée à l'issue de l'au moins une étape de lithographie ultérieure ou dans lequel l'au moins une marque de positionnement (116) est supprimée au cours de l'au moins une étape de lithographie ultérieure.

7. Procédé selon l'une quelconque des deux revendications précédentes, dans lequel l'étape de transfert comprend une étape de gravure de la couche de résine (110) et du substrat (100), la gravure ayant une sélectivité sensiblement identique pour la résine et pour le substrat (100).

8. Procédé selon l'une quelconque des trois revendications précédentes, dans lequel l'étape de transfert est exécutée de sorte à transférer le au moins un motif final (117, 119) depuis la couche de résine (110) dans le substrat (100) pour former dans le substrat (100) au moins un motif final en trois dimensions présentant deux niveaux de profondeur de gravure.

9. Procédé selon la revendication précédente comprenant une étape d'apport d'un matériau électriquement conducteur dans le au moins un motif final et dans lequel préalablement à l'étape de préparation, on réalise au moins une couche d'un circuit intégré dans le substrat (100) et dans lequel l'étape de transfert et l'étape d'apport sont exécutées de sorte que le matériau électriquement conducteur forme une ligne ainsi qu'une interconnexion verticale reliant ladite ligne à la au moins une couche du circuit intégré.

10. Procédé selon la revendication 1, dans lequel dans lequel la résine (110) est une résine photosensible, dans lequel l'étape de formation de motifs additionnels (118) dans la couche de résine (110) comprend une étape de photolithographie et dans lequel ladite exposition comprend une insolation d'une partie au moins de l'au moins un motif préalable (112).

11. Procédé selon la revendication 1, dans lequel l'étape de formation de motifs additionnels (118) dans la couche de résine (110) comprend une étape de lithographie par faisceau d'électrons ou une étape de lithographie par faisceau d'ions et dans lequel l'exposition comprend une écriture d'une partie au moins de l'au moins un motif préalable (112).

12. Procédé selon l'une quelconque des deux revendications précédentes, dans lequel l'étape de nano-impression est effectuée de manière à faire apparaître un résidu de résine au fond d'un creux formé par le motif préalable (112) et dans lequel l'étape de formation de motifs additionnels (118) est effectuée de sorte à faire disparaître le résidu de résine dans le fond du creux ou de sorte à créer, dans le résidu de résine, au moins une ouverture s'étendant depuis le creux jusqu'au substrat (100).

13. Procédé selon la revendication précédente prise en combinaison avec la revendication 10, dans lequel la résine est une résine photosensible positive, dans lequel l'étape de lithographie ultérieure comprend une étape de photolithographie comprenant une étape d'insolation effectuée de sorte à insoler au moins partiellement le résidu de résine de sorte à faire disparaître le résidu de résine dans le fond du creux ou de sorte à créer au moins une ouverture s'étendant depuis le creux jusqu'au substrat (100).

14. Procédé selon la revendication 1, dans lequel l'étape de lithographie préalable définie des premières zones présentant une première épaisseur (113) et des deuxièmes zones présentant chacune une épaisseur (114) inférieure à la première épaisseur, et dans lequel la au moins une étape de lithographie ultérieure est effectuée de sorte à faire disparaître la résine au moins en partie dans au moins certaines des deuxièmes zones.

15. Procédé selon l'une quelconque des revendications précédentes, comprenant plusieurs étapes de lithographie ultérieures comprenant chacune une étape de formation de motifs additionnels (118), une première étape de lithographie ultérieure comprenant une étape de photolithographie et une deuxième étape de lithographie ultérieure comprenant l'une parmi les étapes suivantes : une étape de photolithographie, une étape de lithographie par faisceau d'électrons, une étape de lithographie par faisceau d'ions.

16. Procédé selon l'une quelconque des revendications précédentes, dans lequel les motifs préalables (112) présentent une profondeur différente de la profondeur des marques de positionnement (116).

17. Procédé selon l'une quelconque des revendications précédentes, dans lequel la profondeur de toutes les marques de positionnement (116) est identique et la profondeur de tous les motifs préalables (112) est identique ou dans lequel le moule (120) présente des reliefs (122) présentant plusieurs hauteurs pour définir des motifs préalables (112) de profondeur différentes.

18. Ensemble multicouches (200) comprenant un substrat (100) surmonté d'une couche de résine (110), la couche de résine (110) comprenant une pluralité de motifs préalables (112) en creux, **caractérisé en ce que** la couche de résine (110) comprend au moins une marque de positionnement (116) formant un relief en creux dans la couche de résine (110) et configurée pour permettre le positionnement d'un appareil de lithographie relativement à cette au moins une marque de positionnement (116) et **en ce que** la au moins une marque de positionnement (116) présente une profondeur supérieure à la profondeur des motifs préalables (112).

19. Procédé de fabrication d'un dispositif microélectronique à partir d'un ensemble multicouches (200) selon la revendication précédente, le procédé comprenant au moins une étape de lithographie pour générer des motifs (118) dans la couche de résine (110) de l'ensemble multicouches (200) et faisant intervenir un appareil de lithographie, dans lequel l'étape de lithographie comprend :
- une étape de positionnement de l'appareil de lithographie, l'étape de positionnement comprenant une étape de détection de l'au moins une marque de positionnement (116) formée dans la couche de résine (110) et une étape de positionnement de l'appareil de lithographie par rapport à l'au moins une marque de positionnement (116) ;
- l'étape de lithographie comprenant en outre une étape de formation de motifs additionnels (118) dans la couche de résine (110) utilisant l'appareil de lithographie positionné en fonction de la au moins une marque de positionnement (116), l'étape de formation des motifs additionnels (118) comprenant l'exposition d'une partie au moins de l'au moins un motif préalable (112) de sorte à former au moins un motif final (117) en creux présentant au moins deux niveaux de profondeur dans la couche de résine (110) ou un motif final (119) en saillie présentant au moins deux niveaux de hauteur (113, 114).

## Patentansprüche

1. Lithographieverfahren, umfassend: eine Vorbereitungsstufe, in deren Verlauf eine Harzschicht (110) auf ein Substrat (100) aufgebracht wird, eine zuvor durchgeführte Lithographiestufe, um wenigstens ein vorheriges Motiv (112) in der Harzschicht (110) zu definieren, **dadurch gekennzeichnet, dass**:
* die vorherige Lithographiestufe eine Nanodruckstufe umfasst, in deren Verlauf eine Reliefs (122) umfassende Form (120) in die Harzschicht (110) eindringt, um das wenigstens eine vorherige Motiv (112) und wenigstens eine in der Harzschicht (110) bildende Positionierungsmarkierung (116) zu generieren, wobei wenigstens einige der von der Form (120) generierten Motive unterschiedliche Tiefen aufweisen;
* und dass es wenigstens eine spätere Lithographiestufe umfasst, die auf die Harzstufe (110) angewendet wird und die folgenden Stufen umfasst:
- eine vorherige Positionierungsstufe, bestehend aus der Positionierung der Lithographiemittel in Abhängigkeit von der wenigstens einen Positionierungsmarke (116)
- wenigstens eine Bildungsstufe von zusätzlichen Motiven (118) in der Harzschicht (110), die in Abhängigkeit von der wenigstens einen Positionierungsmarkierung (116) positionierten Lithographiemittel verwendet, wobei die Bildung der zusätzlichen Mittel (118) eine Expositionsstufe wenigstens eines Teils eines vorherigen Motivs (112) umfasst.

2. Verfahren gemäß Anspruch 1, bei dem die Bildungsstufe der zusätzlichen Motive (118) derart durchgeführt wird, dass in dem Harz (110) wenigstens ein hervorstehendes finales Motiv (119) gebildet wird, das wenigstens zwei Höhenniveaus (113, 114) aufweist oder derart durchgeführt wird, dass wenigstens ein vorheriges Motiv (112) mit einem zusätzlichen Motiv (118) überlagert wird, um in dem Harz (110) wenigstens ein finales Motiv (117) im Tiefdruck zu formen, das wenigstens zwei Tiefenniveaus in der Harzschicht (110) aufweist.

3. Verfahren gemäß Anspruch 1, bei dem die Positionierungsstufe das Erfassen der Positionierungsmarkierungen (116) per Lichtbrechung umfasst.

4. Verfahren gemäß Anspruch 1, bei dem wenigstens eines der zusätzlichen Motive von dem wenigstens einen vorherigen Motiv getrennt ist.

5. Verfahren gemäß Anspruch 1, im Anschluss an die wenigstens eine spätere Lithographiestufe umfassend eine Übertragungsstufe, bestehend in der Übertragung des wenigstens einen vorherigen Motivs (112) und der zusätzlichen Motive (118) von der Harzschicht (110) in das Substrat (100).

6. Verfahren gemäß dem voranstehenden Anspruch, bei dem die wenigstens eine Positionierungsmarkierung (116) nach Abschluss der wenigstens einen späteren Lithographiestufe beibehalten wird oder bei dem die wenigstens eine Positionierungsmarkierung (116) im Verlauf der wenigstens einen späteren Lithographiestufe unterdrückt wird.

7. Verfahren gemäß einem der zwei voranstehenden Ansprüche, bei dem die Übertragungsstufe eine Gravurstufe der Harzschicht (110) und des Substrats (100) umfasst, wobei die Gravur eine deutlich identische Selektivität für das Harz und für das Substrat (100) hat.

8. Verfahren gemäß einem der drei voranstehenden Ansprüche, bei dem die Übertragungsstufe derart ausgeführt ist, dass das wenigstens eine finale Motiv (117, 119) von der Harzschicht (110) in das Substrat (100) übertragen wird, um in dem Substrat (100) wenigstens ein finales Motiv in drei Dimensionen zu formen, das zwei Gravurtiefenniveaus aufweist.

9. Verfahren gemäß dem voranstehenden Anspruch, umfassend eine Eintragungsstufe eines elektrisch leitenden Materials in dem wenigstens einen finalen Motiv und bei dem vor der Vorbereitungsstufe wenigstens eine Schicht eines integrierten Schaltkreises in dem Substrat (100) realisiert wird und bei dem die Übertragungsstufe und die Eintragungsstufe derart ausgeführt werden, dass das elektrisch leitende Material eine Linie sowie eine vertikale Vernetzung formt, die die genannte Linie mit der wenigstens einen Schicht des integrierten Schaltkreises verbindet.

10. Verfahren gemäß Anspruch 1, bei dem das Harz (110) ein fotosensibles Harz ist, bei dem die Bildungsstufe von zusätzlichen Motiven (118) in der Harzschicht (110) eine Fotolithographiestufe umfasst und bei dem die genannte Exposition eine Insolation wenigstens eines Teils des wenigstens einen vorherigen Motivs (112) umfasst.

11. Verfahren gemäß Anspruch 1, bei dem die Bildungsstufe von zusätzlichen Motiven (118) in der Harzschicht (110) eine Lithographieschicht pro Elektronenstrahl oder eine Lithographiestufe pro lonenstrahl umfasst und bei dem die Exposition ein Beschreiben wenigstens eines Teils des wenigstens einen vorherigen Motivs (112) umfasst.

12. Verfahren gemäß einem der zwei voranstehenden Ansprüche, bei dem die Nanodruckstufe derart durchgeführt wird, dass ein Harzrückstand im Boden eines Hohlraums durch das vorherige Motiv (112) geformt wird und bei dem die Bildungsstufe von zusätzlichen Motiven (118) derart durchgeführt wird, dass der Harzrückstand im Boden des Hohlraums verschwindet oder derart, dass in dem Harzrückstück sich wenigstens eine Öffnung von dem Hohlraum bis zum Substrat (100) erstreckt.

13. Verfahren gemäß dem voranstehenden Anspruch in Verbindung mit dem Anspruch 10, bei dem das Harz ein positives fotosensibles Harz ist, bei dem die spätere Lithographiestufe eine Fotolithographiestufe, umfassend eine Insolationsstufe, umfasst, die derart durchgeführt wird, dass der Harzrückstand wenigstens teilweise derart insoliert wird, dass der Harzrückstand im Boden des Hohlraums verschwindet oder derart, dass sich wenigstens eine Öffnung von dem Hohlraum bis zu dem Substrat (100) erstreckt.

14. Verfahren gemäß Anspruch 1, bei dem die vorherige Lithographiestufe die ersten, eine erste Dicke (113) aufweisende Zonen und zweite Zonen definiert, die jeweils eine geringere Dicke (114) als die erste Dicke aufweisen, und bei dem die wenigstens eine spätere Lithographiestufe derart durchgeführt wird, dass das Harz wenigstens zum Teil in wenigstens bestimmten zweiten Zonen verschwindet.

15. Verfahren gemäß einem der voranstehenden Ansprüche, umfassend mehrere spätere Lithographiestufen, umfassend jeweils eine Bildungsstufe zusätzlicher Motive (118), wobei eine erste spätere Lithographiestufe eine Fotolithographiestufe umfasst und eine spätere zweite Lithographiestufe die eine aus den folgenden Stufen umfasst: eine Fotolithographiestufe, eine Lithographiestufe per Elektronenstrahl, eine Lithographiestufe per lonenstrahl.

16. Verfahren gemäß einem der voranstehenden Ansprüche, bei dem die vorherigen Motive (112) eine von der Tiefe der Positionierungsmarkierungen (116) unterschiedliche Tiefe aufweisen.

17. Verfahren gemäß einem der voranstehenden Ansprüche, bei dem die Tiefe aller Positionierungsmarkierungen (116) identisch ist und die Tiefe aller vorherigen Motive (112) identisch ist oder bei dem die Form (120) Reliefs (122) aufweist, die mehrere Höhen aufweisen, um vorherige Motive (112) unterschiedlicher Tiefen zu definieren.

18. Mehrschichtige Gruppe (200), umfassend ein von einer Harzschicht (110) überragtes Substrat (100), wobei die Harzschicht (110) eine Vielzahl von vorherigen Motiven (112) im Tiefdruck umfasst, **dadurch gekennzeichnet, dass** die Harzschicht (110) wenigstens eine Positionierungsmarkierung (116) umfasst, die ein Relief im Tiefdruck in der Harzschicht (110) umfasst und konfiguriert ist, um die Positionierung einer Lithographievorrichtung relativ zu der wenigstens einen Positionierungsmarkierung (116) zu erlauben und dass die wenigstens eine Positionierungsmarkierung (116) eine größere Tiefe als die Tiefe der vorherigen Motive (112) aufweist.

19. Herstellungsverfahren einer mikroelektrischen Vorrichtung aus einer Mehrschichtgruppe (200) gemäß dem voranstehenden Anspruch, wobei das Verfahren wenigstens eine Lithographiestufe umfasst, um Motive (118) in der Harzschicht (110) der Mehrschichtgruppe (200) zu generieren und eine Lithographievorrichtung zum Einsatz bringt, bei dem die Lithographiestufe umfasst:
- eine Positionierungsstufe der Lithographievorrichtung, wobei die Positionierungsstufe eine Erfassungsstufe der wenigstens einen in der Harzschicht geformten Positionierungsmarkierung (116) und eine Positionierungsstufe der Lithographievorrichtung im Verhältnis zu der wenigstens einen Positionierungsmarkierung (116) umfasst;
- die Lithographiestufe, umfassend darüber hinaus eine Bildungsstufe von zusätzlichen Motiven (118) in der Harzschicht (110) und die die in Abhängigkeit von der wenigstens einen Positionierungsmarkierung (116) positionierte Lithographievorrichtung verwendet, wobei die Bildungsstufe der zusätzlichen Motive (118) die Exposition wenigstens eines Teils des wenigstens einen vorherigen Motivs (112) derart umfasst, dass wenigstens ein finales Motiv (117) im Tiefdruck geformt wird, der wenigstens zwei Tiefenniveaus in der Harzschicht (110) oder ein hervorstehendes finales Motiv (119) aufweist, das wenigstens zwei Höhenniveaus (113, 114) aufweist.

## Claims

1. A lithography method comprising: a step of preparation during which a resist layer (110) is positioned on a substrate (100), a preliminary step of lithography performed to define at least one preliminary pattern (112) in the resist layer (110), **characterized in that**:
• the preliminary step of lithography comprises a step of nano-printing during which a mould (120) having reliefs (122) enters the resist layer (110) for generating the at least one preliminary pattern (112) and at least one positioning mark (116) forming a pattern in the resist layer (110), with at least some of the patterns generated by the mould (120) having a different depth;
• and **in that** it comprises at least one subsequent step of lithography applied to the resist layer (110) and comprising the following steps:
- a preliminary step of positioning consisting in positioning lithographic means according to the at least one positioning mark (116),
- at least one step of forming additional patterns (118) in the resist layer (110) using the lithographic means positioned according to the at least one positioning mark (116), with the step of forming additional patterns (118) comprising a step of exposing at least a portion of a preliminary pattern (112).

2. A method according to claim 1, wherein the step of forming additional patterns (118) is so performed as to form in the resist (110) at least one protruding final pattern (119) having at least two height levels (113, 114) or is so performed as to stack at least one preliminary pattern (112) with an additional pattern (118) so as to form, in the resist (110), at least one recessed final pattern (117) having at least two depth levels in the resist layer (110).

3. A method according to claim 1, wherein the step of positioning comprises the detection of the positioning marks (116) by diffraction of light.

4. A method according to claim 1, wherein at least one of the additional patterns is separated from the at least one preliminary pattern.

5. A method according to claim 1, wherein, further to the at least one subsequent step of lithography, a step of transfer consisting in transferring the at least one preliminary pattern (112) and the additional patterns (118) from the resist layer (110) into the substrate (100).

6. A method according to claim 1, wherein the at least one positioning mark (116) is preserved upon completion of the at least one subsequent step of lithography or wherein the at least one positioning mark (116) is suppressed during the at least one subsequent step of lithography.

7. A method according to any one of the preceding two claims, wherein the step of transferring comprises a step of etching the resist layer (110) and the substrate (100), with the etching having a substantially identical selectivity for the resist and for the substrate (100).

8. A method according to any one of the preceding three claims, wherein the step of transferring is so performed as to transfer the at least one final pattern (117, 119) from the resist layer (110) into the substrate (100) to form, in the substrate (100), at least one three-dimensional final pattern having two etching depth levels.

9. A method according to the preceding claim comprising a step of adding the at least one final pattern with an electrically conductive material and wherein, prior to the step of preparation, at least one integrated circuit layer is provided in the substrate (100), and wherein the step of transferring and the step of adding are so performed that the electrically conductive material forms a line and a vertical interconnection connecting said line with the at least one integrated circuit layer.

10. A method according to claim 1, wherein the resist (110) is a photoresist, wherein the step of forming additional patterns (118) in the resist layer (110) comprises a step of photolithography and wherein said exposure comprises an insolation of at least a portion of the at least one preliminary pattern (112).

11. A method according to claim 1, wherein the step of forming additional patterns (8) in the resist layer (10) comprises a step of electron beam lithography or a step of ion beam lithography and wherein the exposure comprises the writing of at least a portion of the at least one preliminary pattern (112).

12. A method according to any one of the preceding two claims, wherein the step of nano-printing is so performed as to reveal a resist residue at the bottom of a recess formed by the preliminary pattern (112) and wherein the step of forming additional patterns (118) is so performed as to remove the resist residue at the bottom of the recess or so as to create, in the resist residue, at least one opening extending from the recess up to the substrate (100).

13. A method according to the preceding claim combined with claim 10, wherein the resist is a positive photoresist, wherein the subsequent step of lithography comprises a step of photolithography comprising a step of insolation so performed as to insolate at least partially the resist residue so as to remove the resist residue at the bottom of the recess or so as to create at least one opening extending from the recess up to the substrate (100).

14. A method according to claim 1, wherein the preliminary step of lithography defines first areas having a first thickness (113) and second areas, each having a thickness (114) lower than the first thickness, and wherein the at least one subsequent step of lithography is so performed as to remove the resist at least partially from at least some of the second areas.

15. A method according to any one of the preceding claims, comprising several subsequent steps of lithography, each comprising a step of forming additional patterns (118), with a first subsequent step of lithography and a second subsequent step of lithography comprising one of the following steps: a step of photolithography, a step of electron beam lithography, a step of ion beam lithography.

16. A method according to any one of the preceding claims, wherein the preliminary patterns (112) have a depth different from the depth of the positioning marks (116).

17. A method according to any one of the preceding claims, wherein the depth of all the positioning marks (116) is identical and the depth of all the preliminary patterns (112) is identical or wherein the mould (120) has reliefs (122) having several heights so as to define preliminary patterns (112) having different depths.

18. A multi-layer assembly (200) comprising a substrate (100) whereon a resist layer (110) is placed, with the resist layer (110) comprising a plurality of recessed preliminary patterns (112), **characterized in that** the resist layer (110) comprises at least one positioning mark (116) forming a recessed relief in the resist layer (110) and so configured as to enable the positioning of a lithography apparatus with respect to such at least one positioning mark (116) and **in that** the at least one positioning mark (116) has a depth greater than the depth of the preliminary patterns (112).

19. A method for manufacturing a microelectronic device from a multi-layer assembly (200) according to the preceding claim, with the method comprising at least one step of lithography for generating patterns (118) in the resist layer (110) of the multi-layer assembly (200) and involving a lithography apparatus, wherein the step of lithography comprises:
- a step of positioning the lithography apparatus, with the step of positioning comprising a step of detecting the at least one positioning mark (116) formed in the resist layer (110) and a step of positioning the lithography apparatus relative to the at least one positioning mark (116);
- the step of lithography further comprising a step of forming additional patterns (118) in the resist layer (110) using the lithography apparatus positioned according to the at least one positioning mark (116), with the step of forming additional patterns (118) comprising exposing at least a portion of the at least one preliminary pattern (112) so as to form at least one recessed final pattern (117) having at least two depth levels in the resist layer (110) or a protruding final pattern (119) with at least two height levels (113, 114).
